# EUROPEAN PATENT APPLICATION

(11) **EP 4 510 184 A1**
(43) Date of publication of application: **19.02.2025**
(21) Application number: 23192162.8
(22) Date of filing: 18.08.2023
(51) Int. Cl.: H01L 23/498

(54) **TERMINAL ELEMENT, AND POWER SEMICONDUCTOR MODULE ARRANGEMENT COMPRISING A TERMINAL ELEMENT**

(71) Applicant: Infineon Technologies AG, 85579 Neubiberg (DE)
(72) Inventor: CHAJNETA, Michal, 59555 Lippstadt (DE); TAKKAC, Alparslan, 59872 Meschede (DE); FROEBUS, Dirk, 59759 Arnsberg (DE)
(74) Representative: Westphal, Mussgnug & Partner, Patentanwälte mbB

(57) **Abstract**

A terminal element for a power semiconductor module arrangement comprises a first end (41) configured to be arranged inside a housing (7) of the power semiconductor module arrangement (100), a second end (42) configured to be arranged outside of the housing (7) of the power semiconductor module arrangement (100), a first section (410) and a second section (420) arranged successively between the first end (41) and the second end (42) along a length (l4) of the terminal element (4), and a third section (430) arranged between the first section (410) and the second section (420), wherein the first section (410) has a first width (w410), the second section (420) extends in a first direction (z) and has a second width (w420) that is greater than the first width (w410), and the third section (430) has a width greater than the first width (w410), and extends in a second direction (y) which is angled relative to the first direction (z).

## Description

### TECHNICAL FIELD

The instant disclosure relates to a terminal element for a power semiconductor module arrangement, and to a semiconductor module arrangement comprising a terminal element.

### BACKGROUND

Power semiconductor module arrangements often include at least one semiconductor substrate arranged in a housing. A semiconductor arrangement including a plurality of controllable semiconductor elements (e.g., two IGBTs in a half-bridge configuration) is arranged on each of the at least one substrate. Each substrate usually comprises a substrate layer (e.g., a ceramic layer), a first metallization layer deposited on a first side of the substrate layer and an optional second metallization layer deposited on a second side of the substrate layer. The controllable semiconductor elements are mounted, for example, on the first metallization layer. The second metallization layer may optionally be attached to a base plate.

Electrically conducting elements are usually provided that allow to electrically contact the semiconductor elements from outside of the housing. Such electrically conducting elements may include simple terminal elements, for example. Terminal elements are generally configured to provide control signals to the substrate and the components mounted thereon. To form a stable mechanical and electrical connection between the substrate and the terminal elements, the terminal elements are generally soldered, sintered or welded to the substrate. The terminal elements and the connections that are formed between the terminal elements and the substrate, however, may be exposed to high thermo-mechanical stress during the operation of the power semiconductor module arrangement. There is a risk that, due to the thermo-mechanical stress, the connections between the terminal elements and the substrate are damaged or even destroyed before the end of the intended lifetime of the power semiconductor module arrangement such that the electrical connection between the terminal elements and the substrate can be diminished or interrupted entirely. The lifetime of the power semiconductor module arrangement, therefore, may be significantly reduced.

There is a need for a terminal element that is less likely to delaminate from the substrate during the intended lifetime of the power semiconductor module arrangement.

### SUMMARY

A terminal element for a power semiconductor module arrangement includes a first end configured to be arranged inside a housing of the power semiconductor module arrangement, a second end configured to be arranged outside of the housing of the power semiconductor module arrangement, a first section and a second section arranged successively between the first end and the second end along a length of the terminal element, and a third section arranged between the first section and the second section, wherein the first section has a first width, the second section extends in a first direction and has a second width that is greater than the first width, and the third section has a width greater than the first width, and extends in a second direction which is angled relative to the first direction.

A power semiconductor module arrangement includes a housing, a substrate arranged inside the housing, and at least one terminal element, wherein the first end of each of the at least one terminal element is arranged inside the housing and electrically and mechanically coupled to the substrate, and the second end of each of the at least one terminal element extends to the outside of the housing.

The invention may be better understood with reference to the following drawings and the description. The components in the figures are not necessarily to scale, emphasis instead being placed upon illustrating the principles of the invention. Moreover, in the figures, like referenced numerals designate corresponding parts throughout the different views.

### BRIEF DESCRIPTION OF THE DRAWINGS

Figure 1 is a cross-sectional view of a power semiconductor module arrangement.
Figure 2 schematically illustrates a terminal element according to embodiments of the disclosure.
Figure 3 schematically illustrates another terminal element according to embodiments of the disclosure.
Figure 4 schematically illustrates a three-dimensional view of one end of a terminal element arranged on a substrate according to embodiments of the disclosure.
Figure 5 schematically illustrates a side view of a terminal element according to embodiments of the disclosure.
Figure 6 schematically illustrates a three-dimensional view of a terminal element arranged in a power semiconductor module arrangement according to embodiments of the disclosure.

### DETAILED DESCRIPTION

In the following detailed description, reference is made to the accompanying drawings. The drawings show specific examples in which the invention may be practiced. It is to be understood that the features and principles described with respect to the various examples may be combined with each other, unless specifically noted otherwise. In the description, as well as in the claims, designations of certain elements as "first element", "second element", "third element" etc. are not to be understood as enumerative. Instead, such designations serve solely to address different "elements". That is, e.g., the existence of a "third element" does not require the existence of a "first element" and a "second element". An electrical line or electrical connection as described herein may be a single electrically conductive element, or include at least two individual electrically conductive elements connected in series and/or parallel. Electrical lines and electrical connections may include metal and/or semiconductor material, and may be permanently electrically conductive (i.e., non-switchable). A semiconductor body as described herein may be made from (doped) semiconductor material and may be a semiconductor chip or be included in a semiconductor chip. A semiconductor body has electrically connecting pads and includes at least one semiconductor element with electrodes.

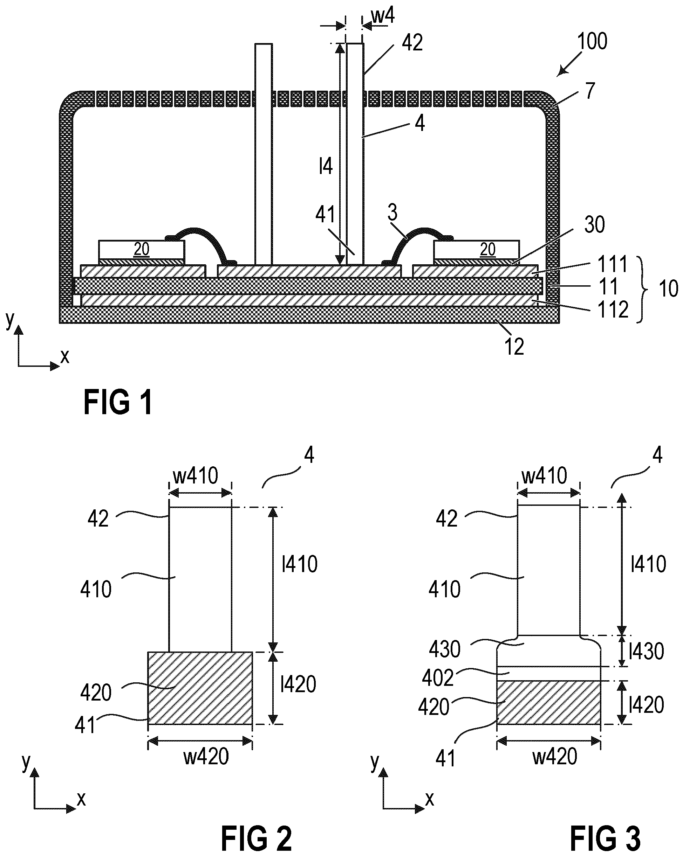

Referring to Figure 1, a cross-sectional view of a power semiconductor module arrangement 100 is schematically illustrated. The power semiconductor module arrangement 100 includes a housing 7 and a substrate 10. The substrate 10 includes a dielectric insulation layer 11, a (structured) first metallization layer 111 attached to the dielectric insulation layer 11, and a (structured) second metallization layer 112 attached to the dielectric insulation layer 11. The dielectric insulation layer 11 is disposed between the first and second metallization layers 111, 112.

Each of the first and second metallization layers 111, 112 may consist of or include one of the following materials: copper; a copper alloy; aluminum; an aluminum alloy; any other metal or alloy that remains solid during the operation of the power semiconductor module arrangement. The substrate 10 may be a ceramic substrate, that is, a substrate in which the dielectric insulation layer 11 is a ceramic, e.g., a thin ceramic layer. The ceramic may consist of or include one of the following materials: aluminum oxide; aluminum nitride; zirconium oxide; silicon nitride; boron nitride; or any other dielectric ceramic. For example, the dielectric insulation layer 11 may consist of or include one of the following materials: Al₂O₃, AlN, SiC, BeO or Si₃N₄. For instance, the substrate 10 may, e.g., be a Direct Copper Bonding (DCB) substrate, a Direct Aluminum Bonding (DAB) substrate, or an Active Metal Brazing (AMB) substrate. Further, the substrate 10 may be an Insulated Metal Substrate (IMS). An Insulated Metal Substrate generally comprises a dielectric insulation layer 11 comprising (filled) materials such as epoxy resin or polyimide, for example. The material of the dielectric insulation layer 11 may be filled with ceramic particles, for example. Such particles may comprise, e.g., SiO₂, Al₂O₃, AlN, or BN and may have a diameter of between about 1µm and about 50µm. The substrate 10 may also be a conventional printed circuit board (PCB) having a non-ceramic dielectric insulation layer 11. For instance, a non-ceramic dielectric insulation layer 11 may consist of or include a cured resin.

The substrate 10 is arranged in a housing 7. In the example illustrated in Figure 1, the substrate 10 is arranged on a base plate 12 which forms a ground surface of the housing 7, while the housing 7 itself solely comprises sidewalls and a cover. This, however, is only an example. It is also possible that the housing 7 further comprises a ground surface and the substrate 10 and the base plate 12 be arranged inside the housing 7. In some power semiconductor module arrangements 100, more than one substrate 10 is arranged on a single base plate 12 or on the ground surface of a housing 7. According to another example, the base plate 12 is omitted and the substrate 10 itself forms a ground surface of the housing 7.

One or more semiconductor bodies 20 may be arranged on the at least one substrate 10. Each of the semiconductor bodies 20 arranged on the at least one substrate 10 may include a diode, an IGBT (Insulated-Gate Bipolar Transistor), a MOSFET (Metal-Oxide-Semiconductor Field-Effect Transistor), a JFET (Junction Field-Effect Transistor), a HEMT (High-Electron-Mobility Transistor), and/or any other suitable semiconductor element.

The one or more semiconductor bodies 20 may form a semiconductor arrangement on the substrate 10. In Figure 1, only two semiconductor bodies 20 are exemplarily illustrated. The second metallization layer 112 of the substrate 10 in Figure 1 is a continuous layer. The first metallization layer 111 is a structured layer in the example illustrated in Figure 1. "Structured layer" means that the first metallization layer 111 is not a continuous layer, but includes recesses between different sections of the layer. Such recesses are schematically illustrated in Figure 1. The first metallization layer 111 in this example includes three different sections. This, however, is only an example. Any other number of sections is possible. Different semiconductor bodies 20 may be mounted to the same or to different sections of the first metallization layer 111. Different sections of the first metallization layer 111 may have no electrical connection or may be electrically connected to one or more other sections using electrical connections 3 such as, e.g., bonding wires. Electrical connections 3 may also include connection plates or conductor rails, for example, to name just a few examples. The one or more semiconductor bodies 20 may be electrically and mechanically connected to the substrate 10 by an electrically conductive connection layer 30. Such an electrically conductive connection layer 30 may be a solder layer, a layer of an electrically conductive adhesive, or a layer of a sintered metal powder, e.g., a sintered silver powder, for example.

According to other examples, it is also possible that the second metallization layer 112 is a structured layer. It is further possible to omit the second metallization layer 112 altogether. It is generally also possible that the first metallization layer 111 is a continuous layer, for example.

The power semiconductor module arrangement 100 further includes terminal elements 4. Only two terminal elements 4 are schematically illustrated in Figure 1. A power semiconductor module arrangement 100, however, generally may include only one or more than two terminal elements 4. The terminal elements 4 are electrically connected to the first metallization layer 111 and provide an electrical connection between the inside and the outside of the housing 7. The terminal elements 4 may be electrically connected to the first metallization layer 111 with a first end 41, while a second end 42 of each of the at least one terminal element 4 protrudes out of the housing 7. Terminal elements 4 may be electrically contacted from the outside at their respective second ends 42. A first part of a terminal element 4 may extend through the inside of the housing 7 in a vertical direction y. The vertical direction y is a direction perpendicular to a top surface of the substrate 10, wherein the top surface of the substrate 10 is a surface on which the at least one semiconductor body 20 is mounted.

The terminal elements 4 illustrated in Figure 1, however, are only examples. Terminal elements 4, for example, may be arranged anywhere within the housing 7. For example, one or more terminal elements 4 may be arranged close to or adjacent to the sidewalls of the housing 7. Terminal elements 4 could also be bent at least once and protrude through the sidewalls of the housing 7 instead of through the cover. The first end 41 of a terminal element 4 may be electrically and mechanically connected to the substrate 10 by means of an electrically conductive connection layer, for example (not explicitly illustrated in Figure 1). Such an electrically conductive connection layer may be a solder layer, a layer of an electrically conductive adhesive, or a layer of a sintered metal powder, e.g., a sintered silver (Ag) powder, for example. According to one example, a connection between the first end 41 of a terminal element 4 and the substrate 10 may be formed by means of ultrasonic welding. The first end 41 of a terminal element 4 may additionally be electrically coupled to the substrate 10 via one or more electrical connections 3, for example. The second ends 42 of a terminal element 4 may be connected to a printed circuit board, for example (not illustrated in Figure 1).

A length l4 of a terminal element 4 between its first end 41 and its second end 42 is generally significantly larger than its width w4 and its thickness d4. Terminal elements 4 often have a rectangular cross-sectional area, for example. According to one example, each of the at least one terminal element 4 has a length l4 between its first and second end 41, 42 that is at least ten times, at least twenty times, or at least thirty times its width w4. According to one example, a thickness d4 of a terminal element 4 is between 0.2 and 1.8mm (millimeters), e.g., 1mm.

Even though the terminal elements 4 are comparably thin and have a comparably small width w4, they may still be stiff to a certain degree. That is, the terminal elements 4 may not be bent without effort. When exposed to typical thermo-mechanical stress during the operation of the power semiconductor module arrangement 100, caused in part by varying coefficients of thermal expansion among various power semiconductor module components, there is a risk that the connections formed between the terminal elements 4 and the substrate 10, e.g., due to a non-negligible amount of tensile stress, are damaged or even destroyed during the intended lifetime of the power semiconductor module arrangement 100 such that the electrical connections between the terminal elements 4 and the substrate 10 can be diminished or interrupted entirely. This effect may also be referred to as delamination. That is, the lifetime of the power semiconductor module arrangement 100 may be significantly decreased.

As is schematically illustrated in Figure 2, a terminal element 4 according to embodiments of the disclosure comprises a first section 410 and a second section 420 arranged successively between the first end 41 and the second end 42 along a length l4 of the terminal element 4. The first section 410 has a first width w410, and the second section 420 has a second width w420 that is greater than the first width w410. If stamped from a single sheet of material, it may be convenient to form the terminal element 4 with a uniform thickness d4 such that a thickness of the first section 410 equals a thickness of the second section 420. However, it is also contemplated that the thickness may vary at different points along the terminal element 4, and/or that the first and second sections 410, 420 have different thicknesses.

The second section 420, due to its greater width w420, may be comparably stiff as compared to the first section 410 having a smaller width w410. Or, in other words, the first section 410 is somewhat flexible as compared to the second section 420. In this way, less force is introduced into the second section 420 by means of the first section 410 when subject to typical thermos-mechanical stress during the operation of the power semiconductor module arrangement 100.

The second section 420 may be electrically and mechanically connected to the substrate 10 with a first end, and may be electrically and mechanically connected to the first section 410 with a second end, opposite the first end. That is, the second section 420 may form a connecting element between the first section 410 and the substrate 10. When force is exerted on the first section 410, and therefore also to the second section 420, during the operation of a power semiconductor module arrangement 100, the narrower first section 410 is able to somewhat elastically deform and compensate the force to a certain degree. Therefore, the force is not, or at least not entirely transferred to the connection formed between the second section 420 and the substrate 10. The effective connection area between the terminal element 4 and the substrate 10, on the other hand, is increased to a certain degree by the increased width w420 of the second section 420. This expanded effective connection area decreases the load placed on the connection between the second section 420 and the substrate 10 during operation of the power semiconductor module arrangement 100, which decreases the likelihood that the terminal element 4 will separate from the substrate 10. The lifetime of the power semiconductor module arrangement 100, therefore, may be significantly increased, as the larger connection is less likely to fail.

In the example illustrated in Figure 2, the width of the terminal element 4 increases rapidly between the first section 410 and the second section 420. In particular, a sharp step is formed between the first section 410 and the second section 420 such that the width increases abruptly between the first section 410 and the second section 420.

The second width w420 may be between 1.05 and 3.00 times greater than the first width w410 in order to prevent excessive load on the connection area between the second section 420 and the substrate 10. According to embodiments of the disclosure, the first width w410 may be between 0.8mm and 6.0mm, depending on module size and/or voltage and current requirements. Generally, the first width w410 of the first section 410 may be as small as possible. The first width w410, however, may be chosen large enough in order to prevent the first section 410 from breaking or being disrupted during the use of the power semiconductor module arrangement as well as during the process of mounting the terminal element 4 to the substrate 10. A length l410 of the first section 410 from the first end 41 towards the second end 42 may be larger than a length l420 of the second section 420 from the second end 42 towards the first end 41. For example, the length l410 of the first section 410 may be between two and ten times the length l420 of the second section 420.

In order to further increase the stability of the terminal element 4, the terminal element 4 further comprises a third section 430 arranged between the first section 410 and the second section 420. This is schematically illustrated in Figure 3. The third section 430 adjoins the second section 420 via a bending interface 402 (bending interface 402 arranged between second section 420 and third section 430). The bending interface 402 and at least a first segment 432 of the third section 430 adjoining the bending interface 402 have the same width w420 as the second section 420, and it therefore follows that the bending interface 402 and at least the first segment 432 of the third section 430 adjoining the bending interface 402 are significantly wider than the width w410 of the first section 410.

The third section 430 protects the terminal element 4 during the ultrasonic welding process. When a terminal element 4 is attached to a substrate 10 by ultrasonic welding, a sonotrode vibrating at high frequency is pressed down upon the upper surface of the second section 420 with a great deal of force, rapidly moving the second section 420 relative to the substrate 10, such that the friction between them causes them to fuse together. The pressure from the sonotrode causes the second section 420 to laterally expand relative to the third section 430. This expansion, especially in combination with the rapid vibration imparted to second section 420 by the sonotrode, places a great deal of stress on the bending interface 402 between the second section 420 and the third section 430. This bending interface 402 could fracture during the ultrasonic welding process if the bending interface 402 and the first segment 432 of the third section 430 were of a reduced width, for example, the width w410 of the first section 410. The same danger is greatly reduced at the interface between third section 430 and first section 410, as this interface is farther away from the second section 420 where the sonotrode-induced expansion and vibration is taking place.

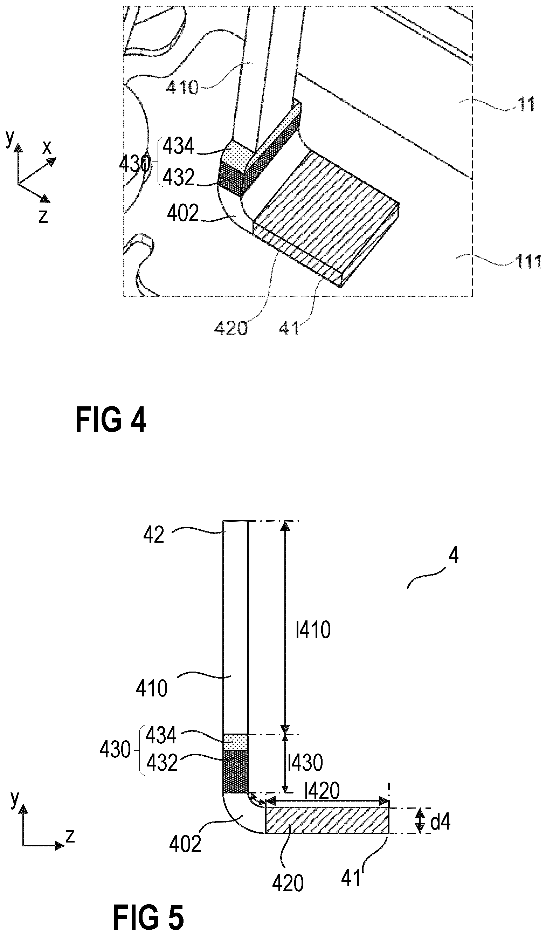

A second segment 434 of the third section 430 that is arranged between the first segment 432 of the third section 430 and the first section 410 may meander from its interface with the first segment 432 of the third section 430 and its interface with the first section 410. As is schematically illustrated in Figure 4, the second segment 434 of the third section 430 may curve inwardly at its interface with the first section 410, for example. This, however, is only an example. The second segment 434 of the third section 430 may have any other suitable shapes. For example, the width of the second segment 434 of the third section 430 may linearly increase from its interface with the first section 410 to its interface with the first segment 432 of the third section 430. In this way, the rapid change of the width as is illustrated in Figure 2 is avoided, and the risk of cracks or ruptures forming in the transition zone between the first section 410 and the first segment 432 of the third section 430 may be significantly reduced (reduced notch effect or stress concentration). Generally, however, it can be said that the third section 430 has a width greater than the first width w410. Terminal elements 4 comprising a first section 410, a second section 420, and a third section 430 may be easily stamped out of a large metal sheet, for example.

Now referring to Figure 4, a terminal element 4 arranged on a substrate 10 is schematically illustrated. As can be seen in the three-dimensional view of Figure 4 as well as in the side view schematically illustrated in Figure 5, the terminal element 4 is bent at least once along its length l4. In particular, the terminal element 4 is bent at the bending interface 402 between the second section 420 and the third section 430 such that the second section 420 adjoining or forming the first end 41 of the terminal element 4 extends in a first direction z, and the third section 430 extends in a second direction y. In this embodiment, the second direction y is seen to be perpendicular to the first direction z, but of course it is contemplated that the second direction y could also extend at any number of different angles relative to the first direction z, depending upon design requirements of a given power semiconductor module 100. The second section 420 may form a connection area of the terminal element 4 that may be connected to the first metal layer 111 of the substrate 10.

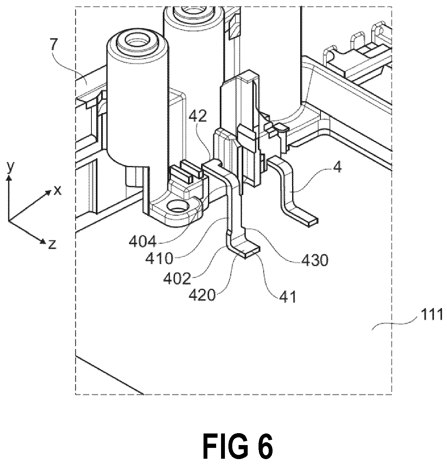

Now referring to Figure 6, a three-dimensional view of a section of a power semiconductor module arrangement 100 is schematically illustrated. A terminal element 4 according to embodiments of the disclosure (left side) is schematically illustrated in comparison to a conventional terminal element 4 having a uniform width (right side). As can be seen, the connection area between the terminal element 4 illustrated on the left side and the first metallization layer 111 is increased as compared to the connection area between the terminal element 4 illustrated on the right side and the first metallization layer 111, while the first section 410 of the terminal element remains somewhat flexible, thereby reducing the stress introduced into the larger connection area.

As is further illustrated in Figure 6, the terminal element 4 may be further bent once along the length l410 of the first section 410 such that a first segment of the first section 410 facing towards the second section 420 extends in the second direction y, and a second segment of the first section 410 adjoining or forming the second end 42 of the terminal element 4 extends in a third direction which is different than the second direction y. In the illustrated embodiment, this third section is seen to extend in the first direction z in parallel to the second section 420, but of course it is contemplated that this third direction could extend in other directions depending upon design requirements of a given power semiconductor module 100. By bending the terminal element 4 at least a second time along its length (e.g., second bending interface 404 within the range of the first section 410), the flexibility of the terminal element 4 may be increased further due to a resulting spring effect of the terminal element 4.

## Claims

1. A terminal element (4) for a power semiconductor module arrangement (100) comprises:
a first end (41) configured to be arranged inside a housing (7) of the power semiconductor module arrangement (100);
a second end (42) configured to be arranged outside of the housing (7) of the power semiconductor module arrangement (100);
a first section (410) and a second section (420) arranged successively between the first end (41) and the second end (42) along a length (l4) of the terminal element (4); and
a third section (430) arranged between the first section (410) and the second section (420), wherein
the first section (410) has a first width (w410),
the second section (420) extends in a first direction (z) and has a second width (w420)
that is greater than the first width (w410), and
the third section (430) has a width greater than the first width (w410), and extends in a
second direction (y) which is angled relative to the first direction (z).

2. The terminal element (4) of claim 1, wherein the second width (w420) is between 1.05 and 3.00 times greater than the first width (w410).

3. The terminal element (4) of claim 1 or 2, wherein a length (l410) of the first section (410) from the first end (41) towards the second end (42) is larger than a length (l420) of the second section (420) from the second end (42) towards the first end (41).

4. The terminal element (4) of claim 3, wherein the length (l410) of the first section (410) is between two and ten times the length (l420) of the second section (420).

5. The terminal element (4) of any of the preceding claims, further comprising a bending interface (402) arranged between the second section (420) and the third section (430), wherein the bending interface (402) has the second width (w420).

6. The terminal element (4) of claim 5, wherein the third section (430) comprises a first segment (432) adjoining the bending interface (402) and having the second width (w420)).

7. The terminal element (4) of claim 6, wherein the third section (430) further comprises a second segment (434) arranged between the first segment (432) and the first section (410).

8. The terminal element (4) of claim 7, wherein the second segment (434) of the third section (430) is curved at its interface with the first section (410).

9. The terminal element (4) of claim 7, wherein the width of the second segment (434) of the third section (430) gradually increases from its interface with the first section (410) towards its interface with the first segment (432) of the third section (430).

10. The terminal element (4) of any of the preceding claims, wherein the first width (w410) is between 0.8mm and 6.0mm.

11. The terminal element (4) of any of the preceding claims, wherein the second direction (y) extends in a direction perpendicular to the first direction (z).

12. The terminal element (4) of any of the preceding claims, wherein the terminal element (4) is bent once along the length (l410) of the first section (410) such that a first segment of the first section (410) facing towards the second section (420) extends in the second direction (y), and a second segment of the first section (410) adjoining or forming the second end (42) of the terminal element (4) extends in a third direction which is different than the second direction (y).

13. The terminal element (4) of claim 12, wherein the third direction is parallel to the first direction (z).

14. A power semiconductor module arrangement (100) comprising,
a housing (7);
a substrate (10) arranged inside the housing (7); and
at least one terminal element (4) according to any of claims 1 to 12, wherein the first end (41) of each of the at least one terminal element (4) is arranged inside the housing (7) and electrically and mechanically coupled to the substrate (10), and the second end (42) of each of the at least one terminal element (4) extends to the outside of the housing (7).

15. The power semiconductor module arrangement of claim 14, wherein the entire second section (420) of each of the at least one terminal element (4) is arranged inside the housing (7).

## Amended claims

### Amended claims in accordance with Rule 137(2) EPC.

1. A terminal element (4) for a power semiconductor module arrangement (100) comprises:
a first end (41) configured to be arranged inside a housing (7) of the power semiconductor module arrangement (100);
a second end (42) configured to be arranged outside of the housing (7) of the power semiconductor module arrangement (100);
a first section (410) and a second section (420) arranged successively between the first end (41) and the second end (42) along a length (l4) of the terminal element (4), wherein the second section (420) adjoins or forms the first end (41) and is arranged between the first end (41) and the first section (410); and
a third section (430) arranged between the first section (410) and the second section (420), wherein
the first section (410) has a first width (w410),
the second section (420) extends in a first direction (z) and has a second width (w420)
that is greater than the first width (w410),
the third section (430) has a width greater than the first width (w410), and extends in a
second direction (y) which is angled relative to the first direction (z),
the second width (w420) is between 1.05 and 3.00 times greater than the first width
(w410), and
the first width (w410) is between 0.8mm and 6.0mm.

2. The terminal element (4) of claim 1, wherein a length (l410) of the first section (410) from the first end (41) towards the second end (42) is larger than a length (l420) of the second section (420) from the second end (42) towards the first end (41).

3. The terminal element (4) of claim 2, wherein the length (l410) of the first section (410) is between two and ten times the length (l420) of the second section (420).

4. The terminal element (4) of any of the preceding claims, further comprising a bending interface (402) arranged between the second section (420) and the third section (430), wherein the bending interface (402) has the second width (w420).

5. The terminal element (4) of claim 4, wherein the third section (430) comprises a first segment (432) adjoining the bending interface (402) and having the second width (w420)).

6. The terminal element (4) of claim 5, wherein the third section (430) further comprises a second segment (434) arranged between the first segment (432) and the first section (410).

7. The terminal element (4) of claim 6, wherein the second segment (434) of the third section (430) is curved at its interface with the first section (410).

8. The terminal element (4) of claim 6, wherein the width of the second segment (434) of the third section (430) gradually increases from its interface with the first section (410) towards its interface with the first segment (432) of the third section (430).

9. The terminal element (4) of any of the preceding claims, wherein the second direction (y) extends in a direction perpendicular to the first direction (z).

10. The terminal element (4) of any of the preceding claims, wherein the terminal element (4) is bent once along the length (l410) of the first section (410) such that a first segment of the first section (410) facing towards the second section (420) extends in the second direction (y), and a second segment of the first section (410) adjoining or forming the second end (42) of the terminal element (4) extends in a third direction which is different than the second direction (y).

11. The terminal element (4) of claim 10, wherein the third direction is parallel to the first direction (z).

12. A power semiconductor module arrangement (100) comprising,
a housing (7);
a substrate (10) arranged inside the housing (7); and
at least one terminal element (4) according to any of claims 1 to 11, wherein the first end (41) of each of the at least one terminal element (4) is arranged inside the housing (7) and electrically and mechanically coupled to the substrate (10), and the second end (42) of each of the at least one terminal element (4) extends to the outside of the housing (7).

13. The power semiconductor module arrangement of claim 12, wherein the entire second section (420) of each of the at least one terminal element (4) is arranged inside the housing (7).
